# FASCICULE DE BREVET EUROPEEN

(11) **EP 3 685 018 B1**
(45) Date de publication et mention de la délivrance du brevet: **26.04.2023**
(21) Numéro de dépôt: 18807683.0
(22) Date de dépôt: 21.09.2018
(51) Int. Cl.: F01D 5/28, C23C 4/08, C22C 19/00, C22C 19/05, C23C 28/00, C23C 14/16

(54) **PIÈCE DE TURBINE EN SUPERALLIAGE COMPRENANT DU RHÉNIUM ET/OU DU RUTHÉNIUM ET PROCÉDÉ DE FABRICATION ASSOCIÉ**
TURBINENTEIL AUS EINER SUPERLEGIERUNG MIT RHENIUM UND/ODER RUTHENIUM UND ZUGEHÖRIGES HERSTELLUNGSVERFAHREN
TURBINE PART MADE OF SUPERALLOY COMPRISING RHENIUM AND/OR RUTHENIUM AND ASSOCIATED MANUFACTURING METHOD

(30) Priorité: 21.09.2017 FR 1700965
(43) Date de publication de la demande: 29.07.2020
(73) Titulaire: Safran, 75015 Paris (FR)
(72) Inventeur: SABOUNDJI, Amar, 77550 Moissy-Cramayel (FR); JAQUET, Virginie, 77550 Moissy-Cramayel (FR)
(74) Mandataire: Regimbeau
(86) Numéro de dépôt international: PCT/FR2018/052314
(87) Numéro de publication internationale: WO 2019/058068

(56) Documents cités:
- EP-A1- 1 652 964
- EP-A1- 3 048 187
- US-A1- 2009 185 944
- US-A1- 2010 330 295
- US-A1- 2013 095 346

## Description

### DOMAINE DE L'INVENTION

L'invention concerne une pièce de turbine, telle qu'une aube de turbine ou une ailette de distributeur par exemple, utilisée dans l'aéronautique.

### ETAT DE LA TECHNIQUE

Dans un turboréacteur, les gaz d'échappement générés par la chambre de combustion peuvent atteindre des températures élevées, supérieure à 1200°C, voire 1600°C. Les pièces du turboréacteur, en contact avec ces gaz d'échappement, telles que les aubes de turbine par exemple, doivent ainsi être capables de conserver leurs propriétés mécaniques à ces températures élevées.

A cet effet, il est connu de fabriquer certaines pièces du turboréacteur en « superalliage ». Les superalliages constituent une famille d'alliages métalliques à haute résistance pouvant travailler à des températures relativement proches de leurs points de fusion (typiquement 0,7 à 0,8 fois leurs températures de fusion).

Afin de renforcer la résistance thermique de ces superalliages et de les protéger contre l'oxydation et la corrosion, il est connu de les recouvrir d'un revêtement jouant un rôle de barrière thermique.

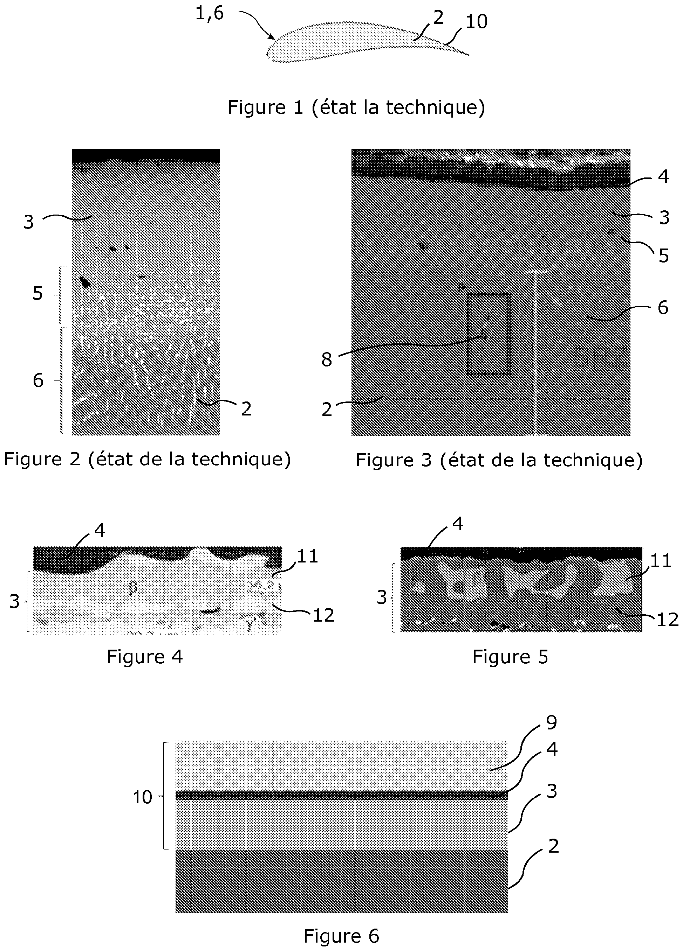

La figure 1 illustre schématiquement une section d'une pièce de turbine 1, par exemple une aube 6 de turbine ou une ailette de distributeur. La pièce 1 comprend un substrat 2 en superalliage métallique monocristallin recouvert d'une barrière thermique 10.

La barrière thermique comprend typiquement une sous-couche métallique, une couche protectrice et une couche thermiquement isolante. La sous-couche métallique recouvre le substrat en superalliage métallique. La sous-couche métallique est elle-même recouverte de la couche protectrice, formée par oxydation de la sous-couche métallique. La couche protectrice permet de protéger le substrat en superalliage de la corrosion et/ou de l'oxydation. La couche thermiquement isolante recouvre la couche protectrice. La couche thermiquement isolante peut être en céramique, par exemple en zircone yttriée.

La sous-couche peut être fabriquée à base d'aluminure de nickel simple β-NiAl ou modifié platine β-NiAlPt. La fraction atomique moyenne en aluminium (comprise entre 0,35 et 0,45) de la sous-couche est suffisante pour former exclusivement une couche protectrice d'oxyde d'aluminium (Al₂O₃) permettant de protéger le substrat en superalliage contre l'oxydation et la corrosion.

Toutefois, lorsque la pièce est soumise à de hautes températures, la différence des concentrations en nickel, et surtout en aluminium, entre le substrat en superalliage et la sous-couche métallique entraîne une diffusion des différents éléments, en particulier du nickel compris dans le substrat vers la sous-couche métallique, et de l'aluminium compris dans la sous-couche métallique vers le superalliage. Ce phénomène est appelé « inter-diffusion ».

L'inter-diffusion peut entraîner la formation de zones de réaction primaires et secondaires (appelées « SRZ » ou *Secondary Reaction Zone* en anglais) dans une partie du substrat en contact avec la sous-couche.

La figure 2 est une microphotographie de la section d'une sous-couche 3a recouvrant un substrat 2. La microphotographie est réalisée avant que la pièce ne soit soumise à une série de cycles thermiques permettant de simuler les conditions en température de la pièce 1 lors de son utilisation. Le substrat 2 est riche en rhénium, c'est-à-dire que la fraction massique moyenne en rhénium est supérieure ou égale à 0,04. Il est connu d'utiliser le rhénium dans la composition des superalliages pour augmenter la résistance au fluage des pièces en superalliage. Typiquement, le substrat 2 présente une phase γ-Ni. La sous-couche 3a est de type β-NiAlPt. Le substrat présente une zone d'inter-diffusion primaire 5, dans la partie du substrat directement recouverte par la sous-couche 3a. Le substrat 2 présente également une zone d'inter-diffusion secondaire 6, directement recouverte par la zone d'inter-diffusion primaire 5. L'épaisseur de la zone d'inter-diffusion secondaire 6 illustrée sur la figure 2 est sensiblement de 35 µm.

La figure 3 est une microphotographie de la section de la sous-couche 3a recouvrant le substrat 2. La microphotographie présente la sous-couche 3a et le substrat 2 après les avoir soumis à la série de cycles thermiques décrite précédemment. La sous-couche 3a recouvre le substrat 2. Le substrat 2 présente une zone d'inter-diffusion primaire 5 et une zone d'inter-diffusion secondaire 6. Localement, l'épaisseur de la zone d'inter-diffusion secondaire 6 peut atteindre 150 µm, comme représenté par le segment blanc dans la figure 3.

Les phénomènes d'inter-diffusion entraînent un appauvrissement prématuré de la sous-couche en aluminium, ce qui favorise des transformations de phases dans la sous-couche (B-NiAl → γ'-Ni₃Al, transformation martensitique). Ces transformations modifient la structure allotropique de la sous-couche 3a et y génèrent des fissures 8, favorisant l'écaillage (ou *rumpling* en anglais) de la couche protectrice d'oxyde d'aluminium.

Ainsi, les inter-diffusions entre le substrat en superalliage et la sous-couche peuvent avoir des conséquences néfastes sur la durée de vie de la pièce en superalliage. US 2009/0185944 A1 décrit un composant de turbine comprenant un substrat en superalliage selon le préambule de la revendication 1.

### RESUME DE L'INVENTION

Un but de l'invention est de proposer une solution pour protéger efficacement une pièce de turbine en superalliage de l'oxydation et de la corrosion, tout en augmentant sa durée de vie, lors de son utilisation, par rapport aux pièces connues.

Un autre but de l'invention est de proposer une solution pour éviter ou limiter la formation de zones de réaction secondaires dans le substrat et l'écaillage de la couche protectrice en oxyde d'aluminium.

Ce but est atteint dans le cadre de la présente invention grâce à une pièce de turbine comprenant un substrat en superalliage base nickel monocristallin, comprenant du rhénium et/ou du ruthénium, et présentant une phase γ'-Ni₃Al majoritaire en volume et une phase γ-Ni, et une sous-couche en superalliage métallique base nickel recouvrant le substrat, caractérisée en ce que la sous-couche présente une phase γ'-Ni₃Al majoritaire en volume et en ce que la sous-couche présente une fraction atomique moyenne en aluminium comprise entre 0,15 et 0,25, en chrome comprise entre 0,03 et 0,08, en platine comprise entre 0,01 et 0,05, en hafnium inférieure à 0,01 et en silicium inférieure à 0,01.

Comme la sous-couche métallique présente une structure allotropique proche de la structure du substrat, la formation de zones de réaction secondaires est empêchée et/ou limitée.

De plus, comme la composition de la sous-couche métallique correspond à la composition d'une sous-couche en condition de travail à un temps suivant une transition martensitique, la structure allotropique de la sous-couche limite ou empêche la formation de zones de réaction secondaires tout en présentant une composition chimique adaptée pour augmenter le temps, en condition de travail, pendant lequel la sous-couche protectrice peut être formée.

La pièce de turbine peut en outre présenter les caractéristiques suivantes :
- la sous-couche présente une phase γ'- Ni₃Al supérieure à 95% en volume ;
- la sous-couche présente une phase γ'-Ni₃Al et une phase β-NiAlPt ;
- la sous-couche présente une phase γ'-Ni₃Al et une phase γ-Ni ;
- la fraction massique de rhénium du substrat est supérieure ou égale à 0,04 ;
- la sous-couche comprend en outre au moins un élément choisi parmi du cobalt, du molybdène, du tungstène, du titane, du tantale ;
- une couche protectrice en oxyde d'aluminium recouvre la sous couche ;
- une couche thermiquement isolante en céramique recouvre la couche protectrice ;
- l'épaisseur de la sous-couche est comprise entre 5 µm et 50 µm.

L'invention concerne en outre une aube de turbine caractérisée en ce qu'elle comprend une pièce telle que définie précédemment.

L'invention concerne en outre une turbomachine caractérisée en ce qu'elle comprend une turbine comprenant une aube de turbine telle que définie précédemment.

L'invention concerne en outre un procédé de fabrication d'une pièce de turbine comprenant une étape de dépôt sous vide d'une sous-couche d'un superalliage base nickel présentant majoritairement en volume une phase γ'-Ni₃Al, sur un substrat en superalliage base nickel comprenant du rhénium et/ou du ruthénium, la sous-couche présentant une fraction atomique moyenne :
- en aluminium comprise entre 0,15 et 0,25 ;
- en chrome comprise entre 0,03 et 0,08 ;
- en platine comprise entre 0,01 et 0,05 ;
- en hafnium inférieure à 0,01 et
- en silicium inférieure à 0,01.

Le dépôt peut être mis en oeuvre par une méthode choisie parmi un dépôt physique en phase vapeur, une projection thermique, une évaporation joule, une ablation laser pulsée et une pulvérisation cathodique.

La sous-couche peut être déposée en co-pulvérisant et/ou en co-évaporant des cibles en métal.

### PRESENTATION DES DESSINS

D'autres caractéristiques et avantages ressortiront encore de la description qui suit, laquelle est purement illustrative et non limitative, et doit être lue en regard des figures annexées, parmi lesquelles :
- la figure 1 illustre schématiquement la section d'une pièce de turbine, par exemple une aube de turbine ou une ailette de distributeur ;
- la figure 2 est une microphotographie de la section d'une sous-couche recouvrant le substrat ;
- la figure 3 est une microphotographie de la section d'une sous-couche recouvrant le substrat ;
- la figure 4 illustre schématiquement la section d'une barrière thermique recouvrant le substrat d'une pièce de turbine selon un mode de réalisation de l'invention ;
- la figure 5 est une microphotographie de la section d'une sous-couche recouvrant un substrat après un traitement thermique ;
- la figure 6 est une microphotographie de la section d'une sous-couche recouvrant le substrat après un traitement thermique.

### DEFINITIONS

On désigne par le terme « superalliage » un alliage complexe présentant, à haute température et à haute pression, une très bonne résistance à l'oxydation, à la corrosion, au fluage et à des contraintes cycliques (notamment mécaniques ou thermiques). Les superalliages trouvent une application particulière dans la fabrication de pièces utilisées dans l'aéronautique, par exemple des aubes de turbine ou de turbomachine, car ils constituent une famille d'alliages à haute résistance pouvant travailler à des températures relativement proches de leurs points de fusion (typiquement 0,7 à 0,8 fois leurs températures de fusion).

Un superalliage peut présenter une microstructure biphasique comprenant une première phase (appelée « phase γ ») formant une matrice, et une deuxième phase (appelée « phase γ' ») formant des précipités durcissant dans la matrice.

La « base » du superalliage désigne le composant métallique principal de la matrice. Dans la majorité des cas, les superalliages comprennent une base fer, cobalt, ou nickel, mais également parfois une base titane ou aluminium.

Les « superalliages base nickel » présentent l'avantage d'offrir un bon compromis entre résistance à l'oxydation, résistance à la rupture à haute température et poids, ce qui justifie leur emploi dans les parties les plus chaudes des turboréacteurs.

Les superalliages base nickel sont constitués d'une phase γ (ou matrice) de type austénitique cubique à face centrée γ-Ni, contenant éventuellement des additifs en solution solide de substitution α (Co, Cr, W, Mo), et d'une phase γ' (ou précipités) de type γ'-Ni₃X, avec X = Al, Ti ou Ta. La phase γ' possède une structure L₁₂ ordonnée, dérivée de la structure cubique à face centrée, cohérente avec la matrice, c'est-à-dire ayant une maille atomique très proche de celle-ci.

De par son caractère ordonné, la phase γ' présente la propriété remarquable d'avoir une résistance mécanique qui augmente avec la température jusqu'à 800°C environ. La cohérence entre les phases γ et γ' confère une tenue mécanique à chaud très élevée des superalliages à base nickel, qui dépend elle-même du ratio γ/γ' et de la taille des précipités durcissants.

Un superalliage est, dans l'ensemble des modes de réalisation de l'invention, riche en rhénium et/ou en ruthénium, c'est-à-dire que la fraction atomique moyenne en rhénium et/ou en ruthénium du superalliage est supérieure ou égale à 0,04. La présence de rhénium permet d'augmenter la résistance au fluage des pièces en superalliage comparativement aux pièces en superalliage sans rhénium sans ruthénium. De plus, la présence de ruthénium permet d'améliorer la répartition d'éléments chimiques réfractaires dans les phases γ et γ'.

Les superalliages base nickel présentent ainsi généralement une forte résistance mécanique jusqu'à 700°C, puis une résistance mécanique qui diminue fortement au-delà de 800°C.

Les termes « fraction atomique » désignent la concentration.

### DESCRIPTION DETAILLEE DE L'INVENTION

La figure 4 illustre schématiquement une section de barrière thermique 10 recouvrant le substrat 2 d'une pièce 1 de turbine.

Les éléments illustrés en figure 4 peuvent être indépendamment représentatifs des éléments d'une aube 6 de turbine, d'une ailette de distributeur, ou de tout autre élément, partie ou pièce d'une turbine.

Le substrat 2 est formé en superalliage à base nickel comprenant du rhénium et/ou du ruthénium. La fraction massique moyenne du substrat 2 en rhénium et/ou en ruthénium est supérieure ou égale à 0,04 et préférentiellement comprise entre 0,045 et 0,055.

La barrière thermique comprend une sous-couche métallique 3b, une couche protectrice 4 et une couche thermiquement isolante 9.

Le substrat 2 est recouvert par la sous-couche 3b métallique. La couche métallique 3b est recouverte par la couche protectrice 4. La couche protectrice 4 est recouverte par la couche thermiquement isolante 9.

La composition de la sous-couche 3b métallique déposée présente une fraction atomique moyenne en aluminium comprise entre 0,15 et 0,25, préférentiellement entre 0,19 et 0,23, en chrome comprise entre 0,03 et 0,08, préférentiellement entre 0,03 et 0,06, en platine comprise entre 0,01 et 0,05, en hafnium inférieure à 0,01, préférentiellement inférieure à 0,008, et en silicium inférieure à 0,01, préférentiellement inférieure à 0,008. La composition préférentielle est décrite dans le tableau 1 ci-dessous, la fraction atomique moyenne étant donnée en pourcentage.

**Tableau 1**

| Ni (% At) | Al (% At) | Cr (% At) | Pt (% At) | Hf (% At) | Si (% At) |
|---|---|---|---|---|---|
| base | 19-23 | 3-6 | 1-5 | 0-0,8 | 0-0,8 |

La sous-couche 3b métallique présente une phase γ'-Ni₃Al 12 majoritaire en volume. Ainsi, la structure allotropique de la sous-couche 3b est proche de la structure du substrat 2, permettant d'empêcher la formation de zones de réaction secondaires pendant l'utilisation de la pièce 1 de turbine à des température supérieure à 900°C, et préférentiellement supérieure à 1100°C. Avantageusement, la phase γ'-Ni₃Al est supérieure à 95% en volume dans la sous-couche métallique. Hormis la phase γ'-Ni₃Al, la sous-couche 3b métallique peut présenter une phase β-NiAlPt ou une phase γ-Ni.

La composition chimique et la structure allotropique de la sous-couche 3b ont été déterminées en analysant la composition chimique et la structure d'une sous-couche 3b, initialement de type β-NiAlPt, directement après une phase de transformation martensitique lors d'un traitement de la sous-couche 3b simulant les conditions thermiques d'utilisation de la pièce 1.

La figure 5 est une microphotographie de la section d'une sous-couche 3a, différente d'une sous-couche de l'invention, recouvrant un substrat après un traitement thermique. Le substrat recouvert par la sous-couche 3a est un substrat en superalliage base nickel de type AM1, ne comprenant ni rhénium ni ruthénium. La pièce comprenant la sous-couche 3a a été traité par une série de 250 cycles thermiques, chaque cycle correspondant à un traitement thermique de la pièce comprenant la sous-couche 3a à une température de 1100°C pendant 60 min. La sous-couche 3a présente majoritairement en volume une phase 11 β-NiAlPt et minoritairement en volume une phase 12 γ'-Ni₃Al. La sous-couche 3a est recouverte d'une couche protectrice 4. L'interface entre la sous-couche 3a et la couche protectrice 4 est très irrégulière : elle présente une rugosité suffisamment élevée pour entraîner l'écaillage (ou rumpling) de la couche protectrice 4 lors de l'utilisation de la pièce. Cette rugosité est entraînée pendant le traitement thermique par des transformations martensitiques des phases 11 β-NiAlPt dans la sous-couche 3a.

La figure 6 est une microphotographie de la section d'une sous-couche 3b, conforme à un mode de réalisation de l'invention, recouvrant un substrat 2 en superalliage base nickel monocristallin comprenant du rhénium et/ou du ruthénium, après un traitement thermique. La pièce comprenant la sous-couche 3b a été traité par une série de 500 cycles thermiques, chaque cycle correspondant à un traitement thermique de la pièce 1 comprenant la sous-couche 3b à une température de 1100°C pendant 60 min. La sous-couche 3b présente majoritairement en volume une phase 12 γ'-Ni₃Al et minoritairement en volume une phase 11 β-NiAlPt. La sous-couche 3a est recouverte d'une couche protectrice 4. L'interface entre la sous-couche 3b et la couche protectrice 4 présente une rugosité moins élevée que la rugosité entre la sous-couche 3a et la couche protectrice 4 illustrée sur la figure 5, malgré un traitement thermique du système comprenant la sous-couche 3b plus long que le traitement thermique décrit en référence à la figure 5. Cette différence de rugosité est associée à une transformation martensitique des phases 11 β-NiAlPt de la sous-couche 3b plus rapide que celle des phases 11 β-NiAlPt de la sous-couche 3a. De plus, la sous-couche 3b illustrée dans la figure 6 présente majoritairement en volume une phase 12 γ'-Ni₃Al et minoritairement en volume une phase 11 β-NiAlPt.

La structure allotropique et la composition chimique de la sous-couche 3b, après 500 cycles thermiques ont été analysées et sélectionnées. Cette structure et cette composition correspondent à la structure et aux compositions décrites précédemment, notamment dans le tableau 1.

Ainsi, de par une phase 12 γ'-Ni₃Al majoritaire en volume et de par la composition décrite dans le tableau 1, la sous-couche 3b n'est peu ou pas sujette aux transformations martensitiques entraînant le phénomène de rumpling, tout en présentant une composition permettant d'augmenter le temps, en condition de travail, pendant lequel la sous-couche 4 protectrice peut être formée.

La sous-couche 3b peut être déposée sous vide, par exemple par en phase vapeur (procédé de PVD, acronyme du terme anglais *Physical Vapor Déposition*)*.* Différentes méthodes de PVD peuvent être utilisées pour la fabrication de la sous-couche 3b, telles que la pulvérisation cathodique, l'évaporation joule, l'ablation laser et le dépôt physique en phase vapeur assisté par faisceau d'électrons. La sous-couche 3b peut également être déposée par projection thermique.

Ainsi, la sous-couche 3b peut être déposée sur le substrat 2 en présentant, avant tout traitement thermique, une composition chimique et une structure allotropique adaptée pour éviter le phénomène de rumpling.

Ces méthodes de dépôt permettent également une simplification de la formation de la sous-couche 3b sur le substrat 2 ainsi qu'un meilleur contrôle de la composition chimique de la sous-couche 3b.

Enfin, ces méthodes de dépôt permettent de contrôler précisément l'épaisseur de la sous-couche 3b, contrairement aux méthodes de formation de sous-couche métallique par diffusion d'élément chimique. Avantageusement, l'épaisseur de la sous-couche 3b est comprise entre 5 µm est 50 µm.

Plusieurs cibles de matériaux métalliques différents peuvent être utilisées en parallèle, de manière simultanée, lors du dépôt d'une sous-couche 3b. Ce type de dépôt peut être réalisé par co-évaporation ou par co-pulvérisation : la vitesse, respectivement d'évaporation, ou de pulvérisation imposée à chaque cible lors du dépôt de la sous-couche 3b détermine alors la stoechiométrie de ladite couche.

## Revendications

1. Pièce (1) de turbine comprenant un substrat (2) en superalliage base nickel monocristallin, comprenant du rhénium et/ou du ruthénium, et présentant une phase γ'-Ni₃Al majoritaire en volume et une phase γ-Ni, et une sous-couche (3b) en superalliage métallique base nickel recouvrant le substrat (2), **caractérisée en ce que** la sous-couche (3b) présente une phase γ'-Ni₃Al (12) majoritaire en volume et **en ce que** la sous-couche (3b) présente une fraction atomique moyenne :
- en aluminium comprise entre 0,15 et 0,25 ;
- en chrome comprise entre 0,03 et 0,08 ;
- en platine comprise entre 0,01 et 0,05 ;
- en hafnium inférieure à 0,01 et
- en silicium inférieure à 0,01.

2. Pièce selon la revendication 1, dans laquelle la sous-couche (3b) présente une phase γ'- Ni₃Al (12) supérieure à 95% en volume.

3. Pièce selon la revendication 1 ou 2, dans laquelle la sous-couche (3b) présente une phase γ'-Ni₃Al (12) et une phase β-NiAlPt (11).

4. Pièce selon la revendication 1 ou 2, dans laquelle la sous-couche (3b) présente une phase γ'-Ni₃Al (12) et une phase γ-Ni.

5. Pièce selon l'une des revendications 1 à 4, dans laquelle la fraction massique de rhénium du substrat (2) est supérieure ou égale à 0,04.

6. Pièce selon l'une des revendications 1 à 4, dans laquelle la sous-couche (3b) comprend en outre au moins un élément choisi parmi du cobalt, du molybdène, du tungstène, du titane, du tantale.

7. Pièce selon l'une des revendications 1 à 6, comprenant une couche protectrice (4) en oxyde d'aluminium recouvrant la sous couche (3b).

8. Pièce selon la revendication 7, comprenant une couche thermiquement isolante (9) en céramique recouvrant la couche protectrice (4).

9. Pièce selon l'une des revendications 1 à 8, dans laquelle l'épaisseur de la sous-couche (3) est comprise entre 5 µm et 50 µm.

10. Aube (6) de turbine **caractérisée en ce qu'**elle comprend une pièce (1) selon l'une des revendications 1 à 9.

11. Turbomachine **caractérisée en ce qu'**elle comprend une turbine comprenant une aube (6) de turbine selon la revendication 10.

12. Procédé de fabrication d'une pièce (1) de turbine comprenant une étape de dépôt sous vide d'une sous-couche (3b) d'un superalliage base nickel présentant majoritairement en volume une phase γ'-Ni₃Al, sur un substrat (2) en superalliage base nickel comprenant du rhénium et/ou du ruthénium, et présentant une phase γ'-Ni₃Al majoritaire en volume et une phase γ-Ni, la sous-couche (3b) présentant une fraction atomique moyenne :
- en aluminium comprise entre 0,15 et 0,25 ;
- en chrome comprise entre 0,03 et 0,08 ;
- en platine comprise entre 0,01 et 0,05 ;
- en hafnium inférieure à 0,01 et
- en silicium inférieure à 0,01.

13. Procédé selon la revendication 12, dans lequel le dépôt est mis en oeuvre par une méthode choisie parmi un dépôt physique en phase vapeur, une projection thermique, une évaporation joule, une ablation laser pulsée et une pulvérisation cathodique.

14. Procédé selon la revendication 12 ou 13, dans lequel la sous-couche (3b) est déposée en co-pulvérisant et/ou en co-évaporant des cibles en métal.

## Patentansprüche

1. Turbinenteil (1), das ein Substrat (2) aus Superlegierung auf monokristalliner Nickelbasis umfasst, umfassend Rhenium und/oder Ruthenium, und eine volumenmehrheitliche Phase γ'-Ni₃Al und eine Phase γ-Ni aufweist, und eine Unterschicht (3b) aus metallischer nickelbasierter Superlegierung, die das Substrat (2) bedeckt, **dadurch gekennzeichnet, dass** die Unterschicht (3b) eine volumenmehrheitliche Phase γ'-Ni₃Al (12) aufweist und dass die Unterschicht (3b) eine mittlere Atomfraktion aufweist:
- aus Aluminium, die zwischen 0,15 und 0,25 liegt;
- aus Chrom, die zwischen 0,03 und 0,08 liegt;
- aus Platin, die zwischen 0,01 und 0,05 liegt;
- aus Hafnium unter 0,01 und
- aus Silizium unter 0,01.

2. Teil nach Anspruch 1, wobei die Unterschicht (3b) eine Phase γ'-Ni₃Al (12) über 95 Vol.-% aufweist.

3. Teil nach Anspruch 1 oder 2, wobei die Unterschicht (3b) eine Phase γ'-Ni₃Al (12) und eine Phase β-NiAlPt (11) aufweist.

4. Teil nach Anspruch 1 oder 2, wobei die Unterschicht (3b) eine Phase γ'-Ni₃Al (12) und eine Phase γ-Ni aufweist.

5. Teil nach einem der Ansprüche 1 bis 4, wobei die Rhenium-Massenfraktion des Substrats (2) größer oder gleich 0,04 ist.

6. Teil nach einem der Ansprüche 1 bis 4, wobei die Unterschicht (3b) ferner mindestens ein Element umfasst, das aus Kobalt, Molybdän, Wolfram, Titan, Tantal ausgewählt ist.

7. Teil nach einem der Ansprüche 1 bis 6, das eine Schutzschicht (4) aus Aluminiumoxid umfasst, die die Unterschicht (3b) bedeckt.

8. Teil nach Anspruch 7, das eine thermische Isolationsschicht (9) aus Keramik umfasst, die die Schutzschicht (4) bedeckt.

9. Teil nach einem der Ansprüche 1 bis 8, wobei die Dicke der Unterschicht (3) zwischen 5 µm und 50 µm liegt.

10. Turbinenschaufel (6), **dadurch gekennzeichnet, dass** sie ein Teil (1) nach einem der Ansprüche 1 bis 9 umfasst.

11. Turbomaschine, **dadurch gekennzeichnet, dass** sie eine Turbinenschaufel (6) nach Anspruch 10 umfasst.

12. Verfahren zur Herstellung eines Turbinenteils (1), das einen Schritt des Ablagerns im Vakuum einer Unterschicht (3b) aus einer nickelbasierten Superlegierung umfasst, die volumenmehrheitlich eine Phase Y'-Ni₃Al aufweist, auf einem Substrat (2) aus nickelbasierter Superlegierung, die Rhenium und/oder Ruthenium umfasst und eine volumenmehrheitliche Phase γ'-Ni₃Al und eine Phase γ-Ni aufweist, wobei die Unterschicht (3b) eine mittlere Atomfraktion aufweist:
- aus Aluminium, die zwischen 0,15 und 0,25 liegt;
- aus Chrom, die zwischen 0,03 und 0,08 liegt;
- aus Platin, die zwischen 0,01 und 0,05 liegt;
- aus Hafnium unter 0,01 und
- aus Silizium unter 0,01.

13. Verfahren nach Anspruch 12, wobei die Ablagerung durch ein Verfahren durchgeführt wird, das aus einer physikalischen Ablagerung in Dampfphase, einer thermischen Projektion, einer Joule-Verdampfung, einer gepulsten Laserablation und einer Kathodenstrahlpulverisierung ausgewählt ist.

14. Verfahren nach Anspruch 12 oder 13, wobei die Unterschicht (3b) durch Co-Pulverisieren und/oder durch Co-Verdampfen der Metalltargets abgelagert wird.

## Claims

1. A turbine part (1) comprising a substrate (2) made of a single-crystal nickel-base superalloy, comprising rhenium and/or ruthenium, and having a γ'-Ni₃Al phase which is predominant in volume and a γ-Ni phase, and a bond coat (3b) made of a nickel-based metal superalloy covering the substrate (2), **characterized in that** the bond coat (3b) has a γ'-Ni₃Al phase (12) of majority volume and **in that** the bond coat (3b) has an average atomic fraction:
- of aluminum between 0.15 and 0.25;
- of chromium between 0.03 and 0.08;
- of platinum between 0.01 and 0.05;
- of hafnium less than 0.01 and
- of silicon less than 0.01.

2. The part as claimed in claim 1, wherein the bond coat (3b) has a γ'- Ni₃Al (12) phase greater than 95% by volume.

3. The part as claimed in claim 1 or 2, wherein the bond coat (3b) has a γ'-Ni₃Al phase (12) and a β-NiAlPt phase (11).

4. The part as claimed in claim 1 or 2, wherein the bond coat (3b) has a γ'-Ni₃Al phase (12) and a γ-Ni phase.

5. The part as claimed in one of claims 1 to 4, wherein the rhenium mass fraction of the substrate (2) is greater than or equal to 0.04.

6. The part as claimed in one of claims 1 to 4, wherein the bond coat (3b) further comprises at least one element selected from cobalt, molybdenum, tungsten, titanium, tantalum.

7. The part as claimed in one of claims 1 to 6, comprising a protective layer (4) of aluminum oxide covering the bond coat (3b).

8. The part as claimed in claim 7, comprising a thermally insulating ceramic layer (9) covering the protective layer (4).

9. The part as claimed in one of claims 1 to 8, wherein the thickness of the bond coat (3) is between 5 µm and 50 µm.

10. A turbine blade (6) **characterized in that** it comprises a part (1) as claimed in one of claims 1 to 9.

11. A gas turbine engine **characterized in that** it comprises a turbine comprising a turbine blade (6) as claimed in claim 10.

12. A process for manufacturing a turbine part (1) comprising a step of vacuum deposition of a bond coat (3b) of a nickel-based superalloy having a γ'-Ni₃Al phase predominantly in volume, on a substrate (2) made of a nickel-based superalloy comprising rhenium and/or ruthenium and having a γ'-Ni₃Al phase which is predominant in volume and a γ-Ni phase, the bond coat (3b) having an average atomic fraction:
- of aluminum between 0.15 and 0.25;
- of chromium between 0.03 and 0.08;
- of platinum between 0.01 and 0.05;
- of hafnium less than 0.01 and
- of silicon less than 0.01.

13. The process as claimed in claim 12, wherein the deposition is carried out by a method selected from physical vapor deposition, thermal spraying, Joule evaporation, pulsed laser ablation and sputtering.

14. The process as claimed in claim 12 or 13, wherein the bond coat (3b) is deposited by co-spraying and/or co-evaporating metal targets.
